# EUROPEAN PATENT SPECIFICATION

(11) **EP 0 343 862 B1**
(45) Date of publication and mention of the grant of the patent: **07.09.1994**
(21) Application number: 89305056.7
(22) Date of filing: 18.05.1989
(51) Int. Cl.: H01R 43/24

(54) **Method of forming a sealed electrical connector**
Verfahren zum Aufbauen eines abgedichteten elektrischen Steckverbinders
Procédé pour former un connecteur électrique étanche

(30) Priority: 27.05.1988 US 199561
(43) Date of publication of application: 29.11.1989
(73) Proprietor: THE WHITAKER CORPORATION, Wilmington, Delaware 19808 (US)
(72) Inventor: Weigert, Fidelo, D-8801 Duerrwangen (DE)
(74) Representative: Warren, Keith Stanley

(56) References cited:
- DE-U- 8 702 517
- US-A- 3 781 986

## Description

The present invention relates to a method of sealing electrical connectors, particularly those connectors which are used on printed circuit boards.

Electrical connectors are mounted to printed circuit boards for a variety of applications in the electronics industry, for such uses varying from modems for personal computers to sockets for integrated circuit packages, for example the so-called "DIP sockets" and the like. After placing the connectors onto the boards, but prior to soldering of these connectors to the boards, the boards and the connector terminals undergo a cleaning process, where a cleansing fluid, typically referred to as flux, is passed over the connection area to prepare and treat the surfaces for soldering. A problem which results from this process is that, due to the natural surface tension of the flux material, the flux wicks up the terminals and can flow into the area where the electrical connection is made. This flux material can actually cause an electrical isolation between the terminals and the mating electrical component even when the two mating components are fully mated.

DE-U-8702517.5 describes an electrical connector for printed circuit boards, including a housing mounting a plurality of terminal pins, in which the apertures in the housing receiving the pins are sealed against the ingress of flux by a sealing foil fitted over the pins.

According to the present invention, the aforementioned problem is alleviated by a sealing method which is characterized by the steps of providing a sealant material for the electrical connector having a melting temperature which is less than that of the insulating housing of the connector; placing the sealant material adjacent to a rear face of the connector with end portions of the terminals extending through the sealant material; heating the sealant material to the point where the sealant material melts and flows around the terminals; and cooling the sealant material to cure the sealant material.

In a preferred embodiment of the method, the heating step is undertaken in a convection oven. The connector may be rotated within the oven so as uniformly to heat the sealant material.

In the preferred embodiment, the heating step includes the heat transfer equivalent of an oven temperature of 180° C for a duration of one minute. Furthermore, prior to placing the sealant material adjacent to the rear face, the sealant material is cut, or stamped to include apertures extending therethrough to match the terminal pattern.

Preferably, the sealant or sealing material is a hot melt material.

It should be noted that the inventive method is useful with all types of electrical connectors.

An embodiment of the invention will now be described by way of example with reference to the accompanying drawings, in which:-
Figure 1 is an isometric view showing the progression of the method,
Figure 2 is an isometric view showing the electrical connector prior to the placement of the sealant material adjacent to the rear face of the housing,
Figure 3 is an isometric view showing the sealant material placed over the terminals, and placed adjacent to the rear face of the electrical connector, and
Figure 4 is a cross sectional view showing diagrammatically, the progression of the inventive method.

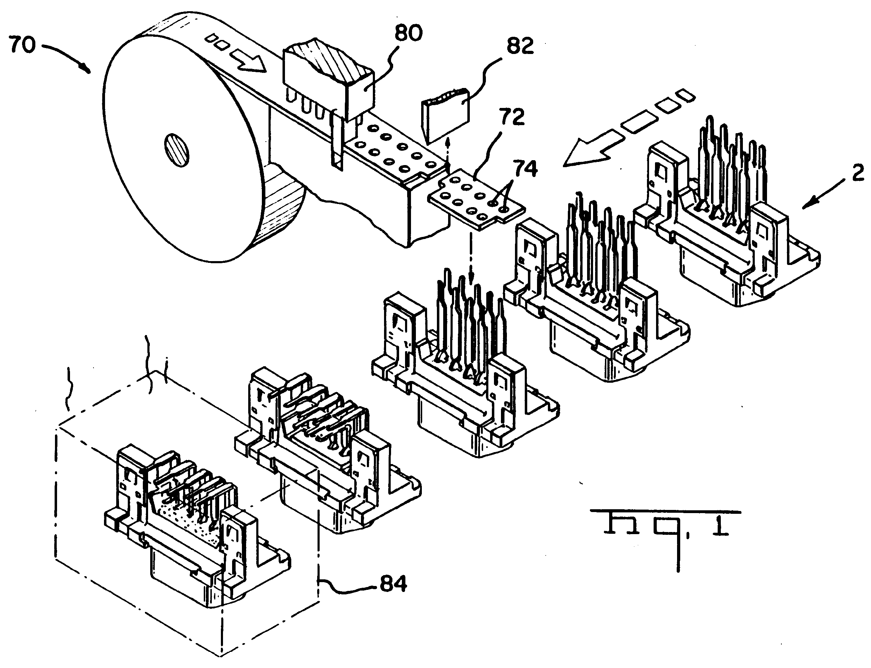

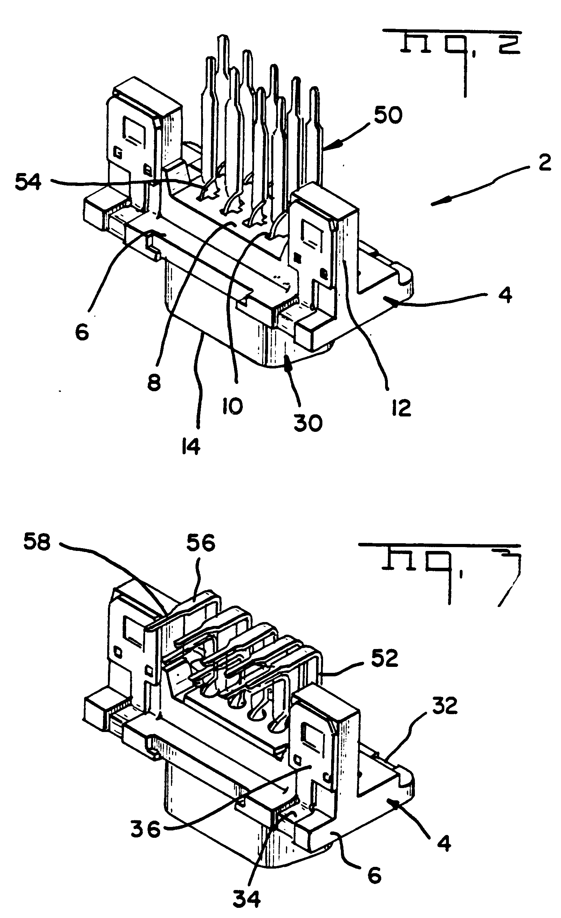

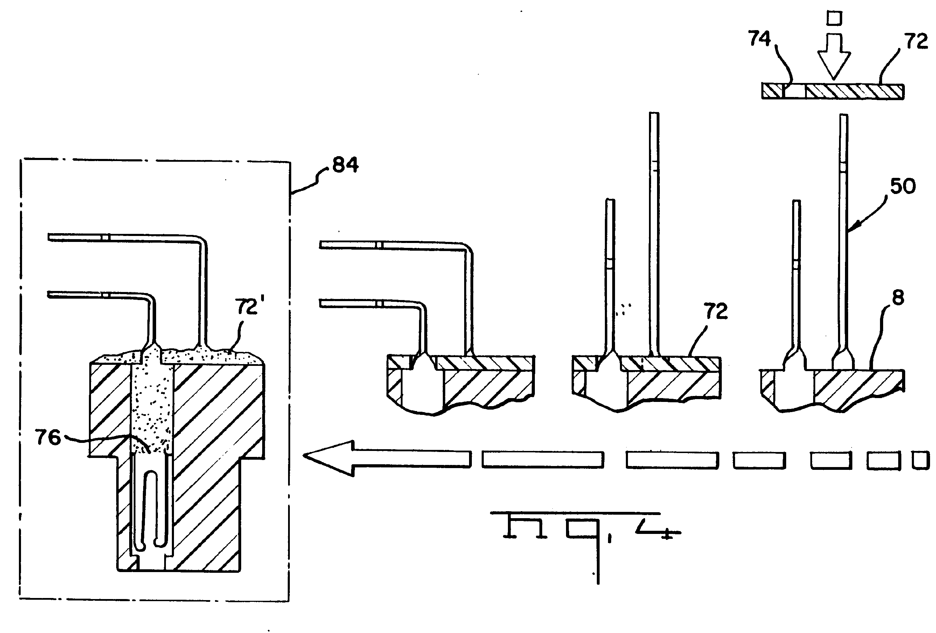

Figure 2 shows a typical electrical connector for use with the inventive method where the electrical connector 2 includes an insulating housing 4 including a plate portion 6 having a platform 12 extending perpendicularly therefrom, the platform being used for mounting on a printed circuit board. Above the platform 12 is a rear face 8 which includes a plurality of apertures 10 therein which extend through the rear face 8 to the front mating face 14. A plurality of electrical terminals 50 are positioned within the apertures 10 and include contact portions adjacent to the front mating face 14. A shield, such as 30, is also included which has tabs 32 and 34 to retain the shield member 30 to the plate portion 6 and further comprises feet 36 for an integral interconnection to ground traces on the printed circuit board. With the connector configured as shown in Figure 2, the electrical connector can then receive the sealing material to form the sealed connector.

As shown in Figure 1, the electrical connector 2 can be preassembled to a position where the terminals 50 are inserted within, and the shield member 30 are mounted to, the electrical connectors, although the end portions of legs 52 of the terminals 50 stand vertically to receive the sealing material. A roll of the sealing material, such as 70, can be moved in a direction transverse to the direction of the connectors and the sealing material can be stamped to conform to the rear face 8 of the electrical connector. In the preferred embodiment of the invention, a stamping die, such as 80, stamps a plurality of apertures 74 into the sealing material 70 while a knife, such as 82, shears the sealing material 70 into individual sealing members 72. The individual sealing members 72 are then placed over the top of the upstanding terminal legs 52 and can be moved downwardly to lie adjacent to the rear face 8 of the electrical connector 2. The terminal legs 52 can then be formed into the desired right angle feature to include perpendicular sections 56 having printed circuit board tab portions 58.

The electrical connectors can then be moved to an oven where the sealing material is heated to a temperature which causes the material to melt and partially flow into the apertures 10 which extend beyond the rear face 8. Due to the natural surface tension of the flowing material, the molten material adheres to the exterior surfaces of the terminal legs 52 and to the interior portions of the apertures 10. It is important to note that the movement or flowing of the material 70 can be controlled by temperature and time duration such that the desired flow is achieved. For example, in the connector shown herein, the material is allowed to flow into the apertures 10 to form a face 76 of the material. The material is not allowed to flow further into the apertures 10, as this would cause the sealing material to flow into the contact area of the terminals. Advantageously, as the desired amount of flow of the molten material is achieved, the connectors are removed from the oven and the molten material quickly cures and solidifies, preventing further flowing of the material.

In the preferred embodiment of the invention, the material which is used as the sealing material is a hot melt thermoplastic which is commercially available from the Chemische Fabrik G.m.b.H. and Company KG as type BS 610 material. Also in the preferred embodiment of the invention, the oven temperature is maintained at approximately 180°C and the electrical connectors are placed in the oven for approximately one minute. Furthermore, in the preferred method, the oven includes a turntable which rotates the connectors to ensure uniform heating to the sealing material.

As shown above, the method is advantageously very easy to accomplish and can be easily incorporated into an existing manufacturing process. The desired material can be obtained in rolled or sheet form and can be automatically inserted over the terminal end portions, without a labor intensive process such as placing discrete seals over the terminals. The connectors can also be automatically transferred into and out of the ovens.

## Claims

1. A method of sealing a connector (2) of the type comprising an insulating housing (4) and a plurality of electrical terminals (50), the insulating housing having a rear face (8) having a plurality of apertures (10) extending therethrough for the receipt of the terminals, with end portions (52) of the terminals extending beyond the rear face (8), the method being characterized by the steps of:
providing a sealant material (70) having a melting temperature which is less than that of the insulating housing (4);
placing the sealant material adjacent to the rear face (8) of the connector (2) with the end portions (52) of the terminals (50) extending through the sealant material;
heating the sealant material to the point where the sealant material melts and flows around the terminals; and
cooling the sealant material to cure the sealant material.

2. The method of claim 1, characterized in that the heating step is undertaken in a convection oven.

3. The method of claim 2, characterized by the step of rotating the connector (2) within the oven uniformly to heat the sealant material (70).

4. The method of claim 1,2 or 3, characterized in that the heating step includes the heat transfer equivalent of an oven temperature of 180° C for a duration of approximately one minute.

5. The method of claim 1,2,3 or 4, characterized in that prior to placing the sealant material (70) adjacent to the rear face (8), the sealant material is formed to include apertures (74) extending therethrough to match the terminal (50) pattern.

6. The method of any preceding claim, characterized in that the sealant material (70) is a hot melt material.

## Patentansprüche

1. Verfahren zum Abdichten eines Verbinders (2) der Art, die ein isolierendes Gehäuse (4) und eine Vielzahl elektrischer Anschlüsse (50) aufweist, wobei das isolierende Gehäuse eine hintere Fläche (8) hat, die eine Vielzahl von sich durch diese hindurch erstreckenden Öffnungen (10) zur Aufnahme der Anschlüsse aufweist, wobei Endabschnitte (52) der Anschlüsse sich über die hintere Fläche (8) hinaus erstrecken, wobei das Verfahren **gekennzeichnet** ist durch die Schritte:
- Bereitstellen eines Abdichtungsmaterials (70) mit einer Schmelztemperatur, die niedriger ist als diejenige des isolierenden Gehäuses (4),
- Anordnen des Abdichtungsmaterials benachbart zu der hinteren Fläche (8) des Verbinders (2), wobei die Endabschnitte (52) der Anschlüsse (50) sich durch das Abdichtungsmaterial hindurch erstrecken,
- Erhitzen des Abdichtungsmaterials bis zu dem Punkt, an dem das Dichtungsmaterial schmilzt und um die Anschlüsse herum fließt, und
- Abkühlen des Abdichtungsmaterials zum Härten des Abdichtungsmaterials.

2. Verfahren nach Anspruch 1, dadurch **gekennzeichnet**, daß der Schritt des Erhitzens in einem Konvektionsofen durchgeführt wird.

3. Verfahren nach Anspruch 2, **gekennzeichnet** durch den Schritt des Drehens des Verbinders (2) innerhalb des Ofens, um das Abdichtungsmaterial (70) gleichförmig zu erhitzen.

4. Verfahren nach Anspruch 1, 2 oder 3, dadurch **gekennzeichnet**, daß der Schritt des Erhitzens eine Wärmeübertragung aufweist, die äquivalent zu einer Ofentemperatur von 180° C für eine Dauer von etwa einer Minute ist.

5. Verfahren nach Anspruch 1, 2, 3 oder 4, dadurch **gekennzeichnet**, daß vor dem Bereitstellen des Abdichtungsmaterials (70) benachbart zu der hinteren Fläche (8) das Dichtungsmaterial verformt wird, um Öffnungen (74) aufzuweisen, die sich durch dieses hindurch erstrecken und zu dem Muster der Anschlüsse (50) passen.

6. Verfahren nach einem vorhergehenden Anspruch, dadurch **gekennzeichnet**, daß das Abdichtungsmaterial (70) ein heißschmelzendes Material ist.

## Revendications

1. Procédé d'obturation d'un connecteur (2) du type comportant un boîtier isolant (4) et plusieurs bornes électriques (50), le boîtier isolant ayant une face arrière (8) à travers laquelle s'étendent plusieurs ouvertures (10) destinées à recevoir les bornes, des parties extrêmes (52) des bornes s'étendant au-delà de la face arrière (8), le procédé étant caractérisé par les étapes qui consistent :
à utiliser une matière d'obturation (70) ayant une température de fusion inférieure à celle du boîtier isolant (4) ;
à placer la matière d'obturation à proximité immédiate de la face arrière (8) du connecteur (2), les parties extrêmes (52) des bornes (50) s'étendant à travers la matière d'obturation ;
à chauffer la matière d'obturation au point où cette matière d'obturation fond et coule autour des bornes ; et
à refroidir la matière d'obturation pour la faire durcir.

2. Procédé selon la revendication 1, caractérisé en ce que l'étape de chauffage est entreprise dans un four à convection.

3. Procédé selon la revendication 2, caractérisé par l'étape consistant à faire tourner le connecteur (2) à l'intérieur du four pour chauffer uniformément la matière d'obturation (70).

4. Procédé selon la revendication 1, 2 ou 3, caractérisé en ce que l'étape de chauffage comprend l'équivalent d'un transfert thermique d'une température du four de 180°C pendant une durée d'environ 1 minute.

5. Procédé selon la revendication 1, 2, 3 ou 4, caractérisé en ce qu'avant la mise en place de la matière d'obturation (70) à proximité immédiate de la face arrière (8), la matière d'obturation est formée de façon à présenter des ouvertures (74) la traversant afin de correspondre à la configuration des bornes (50).

6. Procédé selon l'une quelconque des revendications précédentes, caractérisé en ce que la matière d'obturation (70) est une matière thermofusible.
